# FASCICULE DE BREVET EUROPEEN

(11) **EP 0 645 345 B1**
(45) Date de publication et mention de la délivrance du brevet: **29.01.1997**
(21) Numéro de dépôt: 94402015.5
(22) Date de dépôt: 09.09.1994
(51) Int. Cl.: C01B 6/34

(54) **Procédé de séparation d'un hydrure gazeux ou d'un mélange d'hydrures gazeux à l'aide d'une membrane**
Verfahren zur Trennung eines gasförmigen Hydrids oder einer Mischung von gasförmigen Hydriden mit Hilfe einer Membran
Process for the separation of a gaseous hydride or a mixture of gaseous hydrides with the aid of a membrane

(30) Priorité: 17.09.1993 FR 9311083
(43) Date de publication de la demande: 29.03.1995
(73) Titulaire: L'AIR LIQUIDE, SOCIETE ANONYME POUR L'ETUDE ET L'EXPLOITATION DES PROCEDES GEORGES CLAUDE, F-75321 Paris Cédex 07 (FR)
(72) Inventeur: Bouard, Pascal, F-91210 Draveil (FR); Labrune, Philippe, F-94100 Saint Maur (FR); Villermet, Alain, F-78220 Viroflay (FR); Gastiger, Michel, F-91400 Orsay (FR)
(74) Mandataire: Le Moenner, Gabriel

(56) Documents cités:
- EP-A- 0 239 190
- US-A- 4 178 224
- US-A- 4 941 893
- US-A- 4 957 513
- JOURNAL OF MEMBRANE SCIENCE, vol.70, 1992, AMSTERDAM NL pages 143 - 152 S.T.HSIEH, G.E.KELLER II 'Separation of hydrogen from silane via membranes: a step in the production of ultra-high-purity silicon'
- DATABASE WPI Week 8511, Derwent Publications Ltd., London, GB; AN 85-066277/11 & JP-A-60 022 902 (MITSUBISHI CHEM IND KK) 2 Février 1985
- DATABASE WPI Week 8511, Derwent Publications Ltd., London, GB; AN 85-066277/11 & JP-A-60 022 902

## Description

La présente invention concerne un procédé de séparation de gaz par membrane, et plus particulièrement la séparation d'hydrures ou de mélanges d'hydrures gazeux tels Si₂H₆, AsH₃, PH₃, ou encore GeH₄, fréquemment utilisés dans l'industrie de la microélectronique pour des opérations telles que le dépot de silice SiO₂, ou encore le dopage de zones déterminées d'un semi-conducteur.

L'utilisation de telles atmosphères comprenant des hydrures gazeux pose traditionnellement des questions liées :
a) Aux conditions de sécurité strictes dans lesquelles ces atmosphères doivent être mises en oeuvre. Elles présentent pour la plupart des risques de toxicité élevés auxquels s'ajoutent des risques liés au caractère inflammable de certains. Dans ce contexte, il est souvent recommandé de les utiliser en deçà d'une certaine concentration ou limite sécuritaire dans un gaz vecteur (cette limite variant d'un hydrure à l'autre), la difficulté étant que les applications citées ci-dessus nécessitent généralement des concentrations plus élevées que cette limite sécuritaire, puisqu'elles atteignent parfois plusieurs dizaines de %.
b) A leur coût élevé incitant les utilisateurs à tenter dans la mesure du possible de recycler l'hydrure ou le mélange d'hydrures n'ayant pas réagi au cours du procédé considéré mettant en oeuvre ce ou ces hydrures.

Dans un tel contexte, on comprend tout l'intérêt qu'il y aurait à pouvoir séparer de tels hydrures avec des objectifs tels que :
- L'épuration des mélanges obtenus à la sortie de générateurs de production d'hydrure gazeux qui, outre l'hydrure recherché, produisent des espèces résiduelles telles que.hydrogène, vapeur d'eau etc ...On peut citer ici l'exemple d'un générateur d'arsine par voie électrolytique, produisant à la cathode un mélange d'arsine et d'hydrogène plus ou moins concentré en arsine.
- Le traitement des mélanges obtenus à la sortie de réacteurs mettant en oeuvre de tels hydrures ou mélanges d'hydrures : séparation des hydrures n'ayant pas réagi, et recyclage de ces hydrures à l'entrée du réacteur. On peut citer dans ce domaine l'exemple des réacteurs de fabrication de silicium métal à partir d'un précurseur gazeux du silicium.
- La concentration sécuritaire d'hydrures dans un gaz vecteur : pour n'utiliser et ne transporter que des sources (le plus souvent des bouteilles) d'hydrures gazeux comportant une concentration en hydrure dans un gaz vecteur (neutre ou encore hydrogène) inférieure à la limite sécuritaire évoquée plus haut (par exemple 2% de silane), et ne concentrer l'hydrure ou le mélange d'hydrures que juste en amont du point d'utilisation où une concentration élevée en hydrure est requise.

Les procédés existants permettant de réaliser la séparation d'hydrures gazeux d'un milieu gazeux sont de façon générale très onéreux et présentent de réels dangers de manipulation, qu'il s'agisse de séparation par adsorption ou par distillation cryogénique.

On peut néanmoins citer les travaux récents du document US-A-4,941,893 proposant la séparation de composés gazeux du silicium (SiXₐH_{b}, incluant le silane) de l'hydrogène ou d'acides halogénés (HX, X : Cl, Br, I, F) à l'aide d'une membrane semi-perméable, et où est tout particulièrement recommandée et illustrée l'utilisation d'une membrane composite polysulfone/polysulfone sulfonaté. Les résultats obtenus dans le cas du silane sont tels que pour un mélange initial H₂/SiH₄ à 48.8 % de silane, la concentration en silane en sortie de membrane varie, selon le débit considéré à l'entrée de la membrane, d'environ 52 % à environ 84 %; la concentration en sortie évolue entre environ 1.5 % et 25 % dans le cas d'une concentration en silane à l'entrée de 1 %.

On peut aussi mentionner le document US-A-4,957,513 où est évoquée la séparation par membrane d'hydrogène sélénié (H₂Se) d'un mélange gazeux contenant, outre H₂Se, H₂O et HCl, tel qu'obtenu en sortie d'un générateur d'hydrogène sélénié. Compte tenu des membranes utilisées et des propriétés de perméation de H₂Se dans ces membranes, le mélange enrichi en hydrogène sélénié est obtenu coté perméat de la membrane.

La présente invention a pour objectif de proposer un procédé amélioré de séparation d'hydrures ou de mélanges d'hydrures , dont les performances permettent de séparer avec une sélectivité élevée, comparable et ajustable, des hydrures (ou mélanges d'hydrures) aussi divers que le disilane (Si₂H₆), la phosphine (PH₃), l'arsine (AsH₃), ou encore le germane (GeH₄), d'un milieu gazeux comportant au moins un des gaz du groupe constitué de H₂, He, Ar.

L'aspect "ajustabilité" est tout particulièrement important dans l'optique de pouvoir produire, par une mise en oeuvre adéquate des paramètres du procédé, la concentration désirée d'hydrure (s), et de pouvoir faire varier sans difficulté cette concentration sur demande.

L'invention propose donc un procédé de séparation d'un hydrure gazeux ou d'un mélange d'hydrures gazeux, ne comprenant pas le silane, d'un milieu gazeux contenant au moins un gaz du groupe constitué par H₂, Ar, He, caractérisé en ce que l'on fait passer le milieu gazeux dans un module membranaire, de façon à obtenir en sortie non-perméat du module une concentration du dit hydrure ou du dit mélange d'hydrures supérieure à sa concentration dans le milieu gazeux, et en ce que l'hydrure ou le mélange d'hydrures est compris dans le groupe constitué par le disilane, la phosphine, l'arsine et le germane.

Par module membranaire, on entend selon l'invention, un ensemble d'une ou plusieurs membranes semi-perméables montées en série ou en parallèle, présentant de bonne propriétés de séparation d'hydrures ou de mélanges d'hydrures par rapport à un gaz vecteur (sélectivité), comme c'est le cas pour des membranes du type polyimide ou encore polyaramide (polyimide aromatique). Cet ensemble de membranes peut comporter des membranes de caractéristiques différentes.

Le milieu gazeux traité ainsi sur le module membranaire, pourra provenir de sources très différentes, tant sur le plan de la composition du milieu, que de ses caractéristiques de pression et de débit, comme par exemple :
- Un mélange gazeux provenant d'un générateur d'hydrures gazeux, comprenant outre l'hydrure gazeux, des "impuretés" résiduelles telles que hydrogène, oxygène, vapeur d'eau. On peut citer ici l'exemple d'un générateur d'arsine par voie électrolytique, produisant à la cathode un mélange hydrogène/arsine plus ou moins concentré en arsine.
- Un mélange gazeux, constituant en fait un mélange réactionnel, obtenu à la sortie d'un réacteur mettant en oeuvre le dit hydrure ou lesdits hydrures gazeux; ce milieu réactionnel contenant une proportion du dit hydrure ou des dits hydrures gazeux n'ayant pas réagi; l'application du procédé selon l'invention à ce type de mélange, permet de recycler le mélange obtenu à la sortie non-perméat du module membranaire à l'entrée du réacteur. On peut citer ici l'exemple du dopage de semi-conducteurs utilisant de l'arsine, l'application du procédé selon l'invention à ce type de réacteur permettant de recycler à l'entrée du réacteur l'arsine n'ayant pas réagi au cours du procédé de dopage dont ce réacteur est le siège.
- Un mélange gazeux issu d'un stockage gazeux du type bouteille, comprenant une faible concentration d'hydrure ou d'un mélange d'hydrures gazeux dans un gaz vecteur choisi dans le groupe constitué de H₂, Ar, He, cette concentration étant compatible avec les limites sécuritaires de concentration de ces hydrures dans le dit gaz vecteur : le mélange obtenu à la sortie non-perméat du module membranaire par l'application du procédé selon l'invention à ce type de mélange gazeux est alors dirigé vers un point d'utilisation où la concentration requise du dit hydrure ou mélange d'hydrures gazeux est plus élevée que celle du stockage "sécuritaire".

Selon un aspect de l'invention, le milieu gazeux à traiter sur le module membranaire arrive sur ce module membranaire sous basse pression, compensée par le fait que l'on abaisse, du coté perméat de la membrane, la pression partielle du gaz ou milieu gazeux que l'on souhaite séparer de l'hydrure ou du mélange d'hydrures gazeux. Par "basse pression", on entend, selon l'invention, une pression située dans la gamme 10⁴ Pa absolus à 5 x 10⁵ Pa absolus. Cet aspect "basse pression" de l'invention, est tout particulièrement intéressant pour traiter des mélanges gazeux provenant de certains générateurs d'hydrures, ou encore de certains réacteurs utilisant des hydrures.

Selon une des mises en oeuvre de l'invention, on abaisse, du coté perméat de la membrane, la pression partielle du gaz que l'on souhaite séparer de l'hydrure ou du mélange d'hydrures gazeux, en mettant sous vide le coté perméat de la membrane. On atteint alors coté perméat de la membrane une pression de l'ordre de 1 à 100 Pa (vide primaire).

Selon une autre mise en oeuvre de l'invention, on abaisse, du coté perméat de la membrane, la pression partielle du gaz que l'on souhaite séparer de l'hydrure ou du mélange d'hydrures gazeux, en effectuant un balayage du coté perméat de la membrane, à l'aide d'un gaz, autre que celui que l'on souhaite séparer, et présentant par ailleurs une faible perméation du perméat vers l'intérieur de la membrane, de façon à éviter que ce gaz "outil" n'aille polluer l'intérieur de la membrane, et n'affecte de ce fait le résultat obtenu en sortie de membrane. On utilisera avantageusement, selon l'invention, comme gaz "outil", de l'azote, ou encore du SF₆.

Selon un autre aspect de l'invention, le milieu gazeux à traiter sur le module membranaire arrive sur ce module membranaire sous pression, cette pression pouvant atteindre , selon les sources de gaz 300 x 10⁵Pa et plus (cas de gaz conditionnés en bouteilles). On peut exprimer cette condition expérimentale en terme de différence de pression entre l'entrée et le coté perméat de la membrane. Cette différence se situera alors avantageusement , selon l'invention, en deça de 100 x 10⁵Pa absolus et préférentiellement dans la gamme 10⁵ Pa à 20 x 10⁵ Pa absolus.

On peut noter que pour certaines valeurs de pression un peu à la frontière entre les deux catégories "basse pression" et "en pression" (telles que 3 x 10⁵Pa), on peut parfois éviter l'utilisation d'une méthode d'abaissement de la pression partielle coté perméat (telle que mise sous vide), mais les résultats obtenus grâce à l'utilisation d'une telle méthode ne pourraient qu'en être améliorés.

D'autres caractéristiques et avantages de la présente invention ressortiront de la description suivante de modes de réalisation donnés à titre illustratif mais nullement limitatif, faite en relation avec les dessins annexés, sur lesquels :
- la figure 1 est une représentation schématique d'une installation utilisée pour la mise en oeuvre du procédé selon l'invention.
- la figure 2 représente l'évolution de la pureté en arsine du mélange obtenu en sortie de module membranaire, en fonction du débit d'alimentation de la membrane, dans une installation telle que celle représentée sur la figure 1.

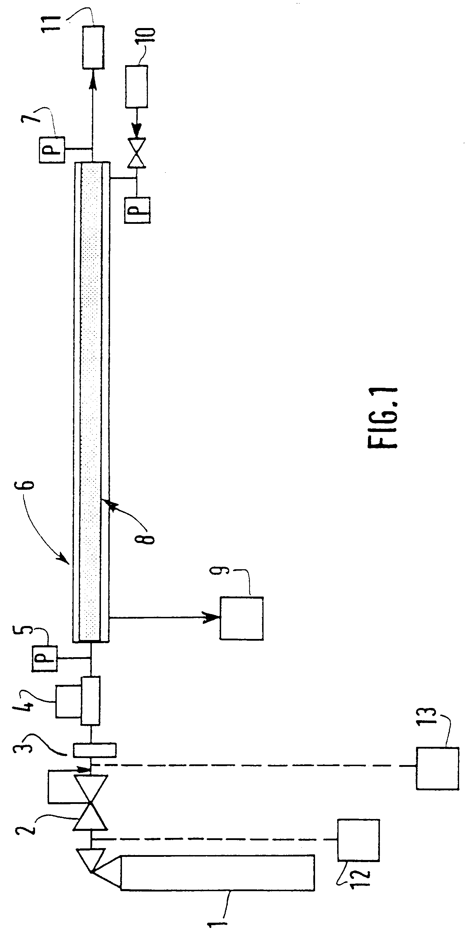

Dans le mode de réalisation représenté sur la figure 1, une bouteille 1 contenant par exemple un mélange arsine/hydrogène à 15 % d'arsine, à 20 x 10⁵ Pa, constitue le milieu gazeux à traiter. Ce mélange est tout d'abord détendu sur un détendeur 2, jusqu'à atteindre une pression de l'ordre de 1 à 2 x 10⁵ Pa absolus, il passe ensuite sur un filtre à particules 3, puis dans un débimètre 4 avant de parvenir à un module membranaire 6. Un manomètre 5 est intercalé entre le débimètre et le module membranaire pour obtenir une mesure de pression du gaz avant son arrivée sur le module.

En pointillés, sont représentées deux lignes d'alimentation alternatives, où le milieu à traiter ne provient pas d'une bouteille, mais provient d'un réacteur mettant en oeuvre un hydrure ou un mélange d'hydrures, ou encore d'un générateur d'hydrures. Selon la pression du milieu gazeux issu de tels dispositifs (réacteur ou générateur), le dispositif sera raccordé à l'installation en amont du détendeur 2 (cas du dispositif 12) ou entre le détendeur 2 et le filtre 3 (cas du dispositif 13).

Le module membranaire 6 est, pour le mode de réalisation représenté, du type membrane à fibres creuses dont la couche active est un polyaramide (polyimide aromatique) et dont les caractéristiques permettent l'obtention d'une surface totale d'échange du module d'environ 0.25 m².

Un capteur de pression 7, permettant d'évaluer la pression du rejet enrichi en hydrure est intercalé en aval du module 6; le rejet enrichi en hydrure est envoyé vers un analyseur 11, pour évaluer la concentration en arsine du rejet.

Pour ce qui est du perméat 8, l'installation permet d'effectuer un tirage au vide à l'aide d'une pompe à vide 9, Elle permet aussi de faire le choix d'un balayage du coté perméat 8 de la membrane à l'aide d'un gaz outil 10, ici en l'occurrence une réserve de SF₆.

Une installation telle que celle représentée sur la figure 1 a été utilisée pour simuler le cas d'un générateur d'arsine par voie électrolytique, produisant à la cathode un mélange arsine/hydrogène contenant 15 % d'arsine, à une pression réduite de 1 à 2 x 10⁵ Pa absolus et à très faible débit.

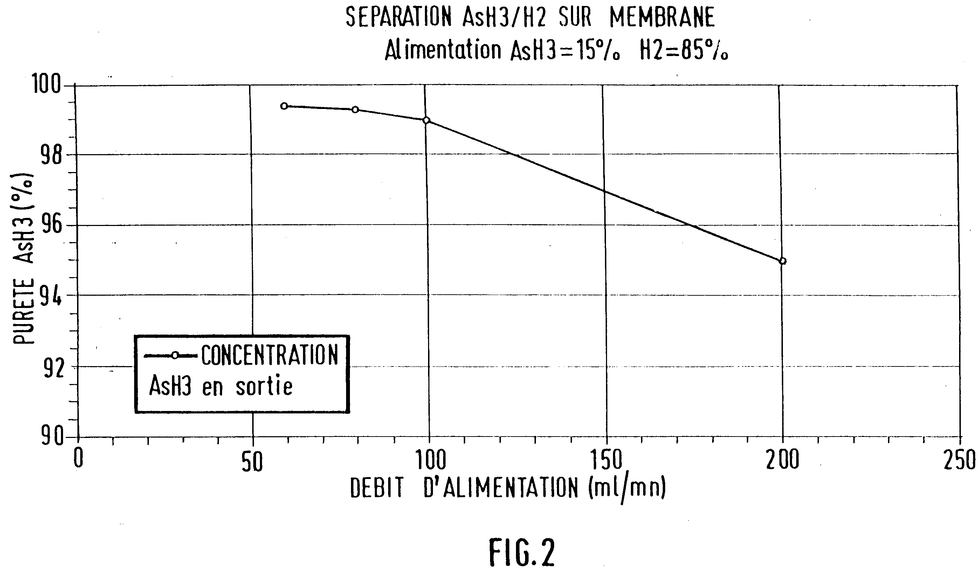

L'application du procédé selon l'invention à un tel mélange, à l'aide de cette installation, à une température de l'ordre de 20 °C, en mettant sous vide le coté perméat de la membrane jusqu'à une pression de l'ordre de 10 Pa absolus, à donné lieu aux résultats représentés sur la figure 2.

On constate sur cette figure que, pour des débits d'alimentation du module membranaire évoluant dans la gamme [50; 100 ml/mn], on concentre l'arsine dans le mélange de sortie du module membranaire à hauteur d'environ 99 à 99.5 % d'arsine dans l'hydrogène.

Ce résultat apporte une réponse au problème d'un générateur d'arsine produisant un mélange insuffisamment concentré en arsine, mais aussi au problème de la concentration sécuritaire d'arsine (vis à vis de l'inflammabilité) à partir d'une bouteille faiblement concentrée.

L'évolution présentée en figure 2 montre que, lorsque l'on augmente le débit d'alimentation du module, la pureté en arsine du mélange de sortie de module membranaire diminue, bien qu'elle se maintienne tout de même à environ 95 % d'arsine dans l'hydrogène pour un débit d'entrée de 200 ml/mn (12 l/h).

Des résultats comparables ont été obtenus en utilisant, au lieu d'une mise sous vide du côté perméat du module, un balayage du perméat, à l'aide de SF₆, à un débit évoluant dans la gamme [50; 200 cm³/mn].

Une excellente reproductibilité des résultats sur plusieurs mois a montré la bonne inertie chimique de la membrane utilisée vis à vis de l'arsine.

## Revendications

1. Procédé de séparation d'un hydrure gazeux ou d'un mélange d'hydrures gazeux, ne comprenant pas le silane, d'un milieu gazeux contenant au moins un gaz du groupe constitué par H₂, Ar, He, caractérisé en ce que l'on fait passer le milieu gazeux dans un module membranaire (6), de façon à obtenir en sortie non-perméat du module une concentration du dit hydrure ou du dit mélange d'hydrures supérieure à sa concentration dans le milieu gazeux, et en ce que l' hydrure ou le mélange d'hydrures est compris dans le groupe constitué par le disilane, la phosphine, l'arsine, et le germane.

2. Procédé selon la revendication 1, caractérisé en ce que le milieu gazeux arrive sous pression sur le module membranaire, la différence de pression entre l'entrée et le coté perméat de la membrane n'excédant pas 100 x 10⁵ Pa absolus.

3. Procédé selon la revendication 2, caractérisé en ce que la différence de pression entre l'entrée et le coté perméat de la membrane est située dans l'intervalle 10⁵ Pa à 20 x 10⁵ Pa absolus.

4. Procédé selon la revendication 1, caractérisé en ce que le milieu gazeux arrive sur le module membranaire sous basse pression.

5. Procédé selon la revendication 4, caractérisé en ce que l'on compense la dite basse pression, en abaissant, du coté perméat de la membrane, la pression partielle du milieu gazeux que l'on sépare du dit hydrure gazeux ou du dit mélange d'hydrures gazeux.

6. Procédé selon la revendication 5, caractérisé en ce que l'on abaisse, du coté perméat (8) de la membrane (6), la pression partielle du milieu gazeux que l'on sépare du dit hydrure gazeux ou du dit mélange d'hydrures gazeux en utilisant une des méthodes suivantes :
- on effectue une mise sous vide du coté perméat (8) de la membrane (6);
- on effectue un balayage du coté perméat (8) de la membrane (6), à l'aide d'un gaz, présentant une faible perméation du perméat vers l'intérieur de la membrane.

7. Procédé selon la revendication 6, caractérisé en ce que le gaz utilisé pour effectuer le balayage est de l'azote.

8. Procédé selon la revendication 6, caractérisé en ce que le gaz utilisé pour effectuer le balayage est du SF₆.

9. Procédé selon l'une des revendications 4 à 8, caractérisé en ce que la pression du milieu gazeux à séparer qui arrive sur le module membranaire se situe dans l'intervalle 10⁴ Pa à 5 x 10⁵Pa absolus.

10. Procédé selon l'une des revendications 1 à 9, caractérisé en ce que le milieu gazeux traité dans le module membranaire est issu d'un générateur de production d'hydrures gazeux.

11. Procédé selon la revendication 10, caractérisé en ce que le générateur d'hydrures gazeux est un génerateur d'arsine par voie électrolytique, produisant à la cathode ledit milieu gazeux, constitué d'un mélange d'arsine et d'hydrogène.

12. Procédé selon l'une des revendications 1 à 9, caractérisé en ce que :
a) le milieu gazeux traité sur le module membranaire est constitué par le mélange réactionnel obtenu à la sortie d'un réacteur mettant en oeuvre l' hydrure ou les hydrures gazeux; ce milieu réactionnel contenant une proportion de l' hydrure ou des hydrures gazeux n'ayant pas réagi;
b) le mélange obtenu à la sortie du module membranaire (6) est ensuite recyclé à l'entrée du réacteur.

13. Procédé selon la revendication 12, caractérisé en ce que le réacteur est un réacteur de dépôt, mettant en oeuvre un précurseur gazeux du silicium.

14. Procédé selon l'une des revendications 1 à 9, caractérisé en ce que :
a) le milieu gazeux traité sur le module membranaire est issu d'un stockage gazeux du type bouteille (1), comprenant une faible concentration de l' hydrure ou mélange d'hydrures gazeux dans un gaz vecteur choisi dans le groupe constitué de H₂, Ar, He, cette concentration étant compatible avec les limites sécuritaires de concentration de ces hydrures dans le dit gaz vecteur;
b) le mélange obtenu à la sortie du module membranaire (6) est alors dirigé vers un point d'utilisation où la concentration requise du dit hydrure ou mélange d'hydrures gazeux est plus élevée que celle du stockage de l'étape a).

15. Procédé selon l'une des revendications 1 à 14, caractérisé en ce que le module membranaire met en oeuvre plusieurs membranes de caractéristiques différentes.

16. Procédé selon l'une des revendications 1 à 15, caractérisé en ce que le module membranaire met en oeuvre au moins une membrane de type polyimide ou polyaramide.

## Claims

1. Process for separating a gaseous hydride or a mixture of gaseous hydrides, not comprising silane, from a gaseous medium containing at least one gas from the group consisting of H₂, Ar, He, characterized in that the gaseous medium is passed through a membranous module (6), so as to obtain at the non-permeate outlet of the module a concentration of the said hydride or said mixture of hydrides greater than its concentration in the gaseous medium, and in that the hydride or mixture of hydrides is comprised within the group consisting of disilane, phosphine, arsine and germane.

2. Process according to claim 1, characterized in that the gaseous medium arrives under pressure at the membranous module, the pressure difference between the inlet and the permeate side of the membrane not exceeding 100 × 10⁵ Pa absolute.

3. Process according to claim 2, characterized in that the pressure difference between the inlet and the permeate side of the membrane is situated within the interval 10⁵ Pa and 20 × 10⁵ Pa absolute.

4. Process according to claim 1, characterized in that the gaseous medium arrives at the membranous module at a low pressure.

5. Process according to claim 4, characterized in that the said low pressure is compensated for by lowering, on the permeate side of the membrane, the partial pressure of the gaseous medium which is separated from the said gaseous hydride or from the said mixture of gaseous hydrides.

6. Process according to claim 5, characterized in that the partial pressure of the gaseous medium which is separated from the said gaseous hydride or from the said mixture of gaseous hydrides is lowered, on the permeate side (8) of the membrane (6) by using one of the following methods :
- the permeate side (8) of the membrane (6) is put under vacuum;
- the permeate side (8) of the membrane (6) is swept with the aid of a gas having a low permeation of permeate towards the inside of the membrane.

7. Process according to claim 6, characterized in that the gas used for sweeping is nitrogen.

8. Process according to claim 6, characterized in that the gas used for sweeping is SF₆.

9. Process according to one of claims 4 to 8, characterized in that the pressure of the gaseous medium to be separated which arrives at the membranous module is situated in the interval 10⁴ Pa to 5 × 10⁵ Pa absolute.

10. Process according to one of claims 1 to 9, characterized in that the gaseous medium treated in the membranous module comes from a generator for producing gaseous hydrides.

11. Process according to claim 10, characterized in that the generator of gaseous hydrides generates arsine by an electrolytic route, producing at the cathode the said gaseous medium, consisting of a mixture of arsine and hydrogen.

12. Process according to one of claims 1 to 9, characterized in that :
a) the gaseous medium treated in the membranous module consists of the reaction mixture obtained at the outlet from a reactor operating with a hydride or gaseous hydrides, this reaction medium containing a proportion of unreacted gaseous hydride or hydrides;
b) the mixture obtained at the outlet from the membranous module (6) is then recycled to the inlet of the reactor.

13. Process according to claim 12, characterized in that the reactor is a deposition reactor, operating with a gaseous precursor of silicon.

14. Process according to one of claims 1 to 9, characterized in that :
a) the gaseous medium treated in the membranous module comes from a gas storage vessel of the cylinder type (1), comprising a low concentration of a gaseous hydride or mixture of gaseous hydrides in a carrier gas selected from the group consisting of H₂, Ar, He, this concentration being compatible with the safety limits for the concentrations of these hydrides in the said carrier gas;
b) the mixture obtained at the outlet from the membranous module (6) is then directed to a point of use where the required concentration of the said gaseous hydride or mixture of gaseous hydrides is higher than that of the storage vessel of stage a).

15. Process according to one of claims 1 to 14, characterized in that the membranous module employs several membranes with different characteristics.

16. Process according to one of claims 1 to 15, characterized in that the membranous module employs at least one membrane of the polyimide or polyaramide type.

## Patentansprüche

1. Verfahren zur Abtrennung eines gasförmigen Hydrids bzw. einer nichtsilanhaltigen Mischung von gasförmigen Hydriden aus einem gasförmigen Medium, das mindestens ein Gas aus der Gruppe bestehend aus H₂, Ar und He enthält, dadurch gekennzeichnet, daß man das gasförmige Medium derart in ein Membranmodul (6) leitet, daß man am Nichtpermeat-Ausgang des Moduls eine höhere Konzentration an dem Hydrid bzw. der Mischung von Hydriden erhält als jene, die im gasförmigen Medium vorliegt, und daß das Hydrid bzw. die Mischung von Hydriden zu der Gruppe bestehend aus Disilan, Phosphin, Arsin und German gehört.

2. Verfahren nach Anspruch 1, dadurch gekennzeichnet, daß das gasförmige Medium unter Druck in das Membranmodul gelangt, wobei der Druckunterschied zwischen dem Eingang und der Permeatseite der Membran 100 x 10⁵ Pa absolut nicht überschreitet.

3. Verfahren nach Anspruch 2, dadurch gekennzeichnet, daß der Druckunterschied zwischen dem Eingang und der Permeatseite der Membran im Bereich von 10⁵ bis 20 x 10⁵ Pa absolut liegt.

4. Verfahren nach Anspruch 1, dadurch gekennzeichnet, daß das gasförmige Medium unter niedrigem Druck in das Membranmodul gelangt.

5. Verfahren nach Anspruch 4, dadurch gekennzeichnet, daß man den niedrigen Druck dadurch ausgleicht, daß man den Partialdruck des gasförmigen Mediums, aus dem das gasförmige Hydrid bzw. die Mischung von gasförmigen Hydriden abgetrennt wird, auf der Permeatseite der Membran erniedrigt.

6. Verfahren nach Anspruch 5, dadurch gekennzeichnet, daß man den Partialdruck des gasförmigen Mediums, aus dem das gasförmige Hydrid bzw. die Mischung von gasförmigen Hydriden abgetrennt wird, auf der Permeatseite (8) der Membran (6) nach einer der folgenden Methoden erniedrigt:
- man setzt die Permeatseite (8) der Membran (6) unter Vakuum;
- man spült die Permeatseite (8) der Membran (6) mit einem Gas, das eine geringe Permeation des Permeats ins Innere der Membran zeigt.

7. Verfahren nach Anspruch 6, dadurch gekennzeichnet, daß es sich bei dem zur Spülung verwendeten Gas um Stickstoff handelt.

8. Verfahren nach Anspruch 6, dadurch gekennzeichnet, daß es sich bei dem zur Spülung verwendeten Gas um SF₆ handelt.

9. Verfahren nach einem der Ansprüche 4 bis 8, dadurch gekennzeichnet, daß der Druck des zu trennenden, in das Membranmodul gelangenden gasförmigen Mediums im Bereich von 10⁴ bis 5 x 10⁵ Pa absolut liegt.

10. Verfahren nach einem der Ansprüche 1 bis 9, dadurch gekennzeichnet, daß das im Membranmodul behandelte gasförmige Medium aus einem Generator zur Herstellung von gasförmigen Hydriden stammt.

11. Verfahren nach Anspruch 10, dadurch gekennzeichnet, daß es sich bei dem Generator zur Herstellung von gasförmigen Hydriden um einen Generator zur Herstellung von Arsin auf elektrolytischem Weg handelt, in dem das aus einem Arsin-Wasserstoff-Gemisch bestehende gasförmige Medium an der Kathode erzeugt wird.

12. Verfahren nach einem der Ansprüche 1 bis 9, dadurch gekennzeichnet, daß
a) das in dem Membranmodul behandelte gasförmige Medium aus dem Reaktionsgemisch besteht, das am Ausgang eines Reaktors, in dem das gasförmige Hydrid bzw. die gasförmigen Hydride verwendet wird bzw. werden, erhalten wird, wobei das Reaktionsmedium einen Anteil an nichtumgesetztem gasförmigem Hydrid bzw. nichtumgesetzten gasförmigen Hydriden aufweist, und
b) das am Ausgang des Membranmoduls (6) erhaltene Gemisch anschließend dem Reaktoreingang wieder zugeführt wird.

13. Verfahren nach Anspruch 12, dadurch gekennzeichnet, daß es sich bei dem Reaktor um einen Ablagerungsreaktor handelt, in dem eine gasförmige Vorstufe des Silicium verwendet wird.

14. Verfahren nach einem der Ansprüche 1 bis 9, dadurch gekennzeichnet, daß
a) das in dem Membranmodul behandelte gasförmige Medium aus einem Vorratsbehälter für gasförmige Stoffe vom Typ Flasche (1) stammt und eine niedrige Konzentration des gasförmigen Hydrids bzw. der Mischung von gasförmigen Hydriden in einem Trägergas aufweist, das ausgewählt ist aus der Gruppe bestehend aus H₂, Ar und He, wobei diese Konzentration mit den unbedenklichen Grenzwerten für die Konzentration dieser Hydride in dem Trägergas in Einklang ist, und
b) das am Ausgang des Membranmoduls (6) erhaltene Gemisch anschließend an eine für seine Verwendung bestimmte Stelle weitergeleitet wird, an der die erforderliche Konzentration des gasförmigen Hydrids bzw. der Mischung von gasförmigen Hydriden größer ist als jene, die im Vorratsbehälter aus Stufe a) vorliegt.

15. Verfahren nach einem der Ansprüche 1 bis 14, dadurch gekennzeichnet, daß bei dem Membranmodul mehrere Membrane verschiedener Eigenschaften zur Anwendung kommen.

16. Verfahren nach einem der Ansprüche 1 bis 15, dadurch gekennzeichnet, daß bei dem Membranmodul mindestens eine Membran vom Typ Polyimid oder Polyaramid zur Anwendung kommt.
